# EUROPEAN PATENT APPLICATION

(11) **EP 2 006 412 A1**
(43) Date of publication of application: **24.12.2008**
(21) Application number: 08165628.2
(22) Date of filing: 03.02.2004
(51) Int. Cl.: C23C 14/34, G11B 7/24, G11B 7/26

(54) **Sputtering target and process for producing the same, thin film for optical information recording medium and process for producing the same**

(30) Priority: 04.03.2003 JP 2003056911
(62) Divisional of application: 04707631.0
(71) Applicant: Nippon Mining & Metals Co., Ltd., Minato-ku Tokyo 105-0001 (JP)
(72) Inventor: Hosono, Hideo c/o Tokyo Institute of Technology, Yokohama-shi, Ibaraki 226-8503 (JP); Ueda, Kazushige c/o dep.of Mat.Science Fac.of Eng, Kitakyushu-shi Fukuoka 804-8550 (JP); Yahagi, Masataka c/o Nikko Materials Co. Ltd., Kitaibaraki-shi Ibaraki 319-1535 (JP); Takami, Hideo c/o Nikko Materials Co. Ltd., Kitaibaraki-shi Ibaraki 319-1535 (JP)
(74) Representative: Hoarton, Lloyd Douglas Charles

(57) **Abstract**

Provided is a sputtering target containing a compound having as its principal component zinc oxide satisfying A_{X}B_{Y}O_{(KaX + KbY)/2}(ZnO)ₘ, 0<X<2, Y = 2-X, 1≦m, where A and B are respectively different positive elements of trivalence or more, and the valencies thereof are respectively Ka and Kb, as well as zinc chalcogenide, and having a relative density of 90% or more and a bulk resistance value of 0.1 Ωcm or less. As a result, obtained is a high density sputtering target that enables high speed deposition upon reducing the influence of heat on a substrate upon forming a film via sputtering, adjustment for thinning the film thickness, and reduction of the generation of particles (dust) and nodules during sputtering, and in which the crystal grains are fine, as well as the manufacturing method thereof. In particular, obtained is a thin film for an optical information recording medium optimum for use as a protective film, as well as the manufacturing method thereof.

## Description

### TECHNICAL FIELD

The present invention relates to a sputtering target having amorphous stability in a thin film for an optical information recording medium protective layer, which allows direct current (DC) sputtering upon forming the film via sputtering, has minimal arcing during sputtering, is capable of reducing particles (dust) and nodules resulting therefrom, has high density and small variation in quality, and is capable of improving the productivity, as well as to the manufacturing thereof. The present invention also relates to a thin film for an optical information recording medium (particularly used as a protective film) as well as to the manufacturing thereof.

### BACKGROUND ART

In recent years, technology of high density optical recording disks such as high density optical information recording mediums capable of rewriting without requiring a magnetic head has been developed, and these disks are rapidly being commercialized. In particular, CD-RW appeared for the first time in 1977 as a rewritable CD, and is the most popular phase change optical disk today. This CD-RW can be rewritten roughly 1000 times. Further, DVD-RW for use as a DVD has been developed and commercialized, and the layer structure of this disk is the same as a CD-RW. This DVD-RW can be rewritten roughly 1000 to 10000 times.

The recording principle employing this phase change optical disk is briefly explained below. This phase change optical disc performs the recording/reproduction of information by heating and increasing the temperature of a recording thin film on a substrate by irradiating a laser beam thereto, and generating a crystallographic phase change (amorphous ⇔ crystal) in the structure of such recording thin film. More specifically, the reproduction of information is conducted by detecting the change in the reflectivity caused by the change in the optical constant of the phase. The aforementioned phase change is performed with the irradiation of a laser beam narrowed down to a diameter of approximately several hundred nm to several µm.

Here, for example, when a 1 µm laser beam passes through at a linear velocity of 10m/s, light is irradiated to a certain point on the optical disc for 100ns, and it is necessary to perform the aforementioned phase change and detect the reflectivity within such time frame.

Moreover, in order to realize the foregoing crystallographic phase change; that is, the phase change of the amorphous and crystal, not only will the phase change recording layer be subject to repeated heating and rapid cooling, the peripheral dielectric protective layer and the reflective film of aluminum alloy will also be repeatedly subject thereto.

In light of the above, a phase change optical disc used as a CD-RW or DVD-RW has a four-layer structure wherein, for instance, both sides of a Ag-In-Sb-Te or Ge-Sb-Te recording thin film layer or the like are sandwiched with a zinc sulfide-silica (ZnS-SiO₂) high-melting point dielectric or the like, and an aluminum alloy reflective layer is additionally provided thereto. Further, in order to increase the number of times the disk can be rewritten, a surface phase is added between a memory layer and protective layer as necessary.

Among the above, in addition to being demanded of an optical function capable of increasing a reflectivity difference of the amorphous portion and crystal portion, the reflective layer and protective layer are also demanded of a function for preventing the deformation caused by the moisture resistance or heat of the recording thin film as well as a function for controlling the thermal conditions upon recording (c.f. "Kogaku" magazine, volume 26, no. 1, pages 9 to 15).

As described above, the protective layer of a high-melting point dielectric must be durable against repeated thermal stress caused by the heating and cooling, must not allow such thermal effect to influence the reflective film or other areas, and it is also required to be thin, of low reflectivity, and possess strength to prevent deterioration. From this perspective, the dielectric protective layer plays an important role.

The dielectric protective layer described above is usually formed with the sputtering method. This sputtering method makes a positive electrode target and a negative electrode target face each other, and generates an electric field by applying a high voltage between the substrates thereof and the targets under an inert gas atmosphere. The sputtering method employs a fundamental principle where the inert gas are ionized, plasma which consist of electrons and the positive ion is formed, the positive ion in this plasma extrudes the atoms structuring the target by colliding with the target (negative electrode) surface, and the extruded atoms adhere to the opposing substrate surface, wherein the film is formed thereby.

Conventionally, ZnS-SiO₂ has been widely used as the protective layer of a rewritable optical recording medium due to its superior characteristics regarding optical characteristics, heat characteristics, and adhesiveness with the recording layer. And, conventionally, a ceramic target such as ZnS-SiO₂ was used to form a thin film of several hundred to several thousand Å.

Nevertheless, since the bulk resistance value of the target is high, these materials cannot be deposited with a direct current sputtering device, and a radio frequency sputtering (RF) device is generally used. In reality, not only is this radio frequency sputtering (RF) device expensive, it has numerous defects such as the sputtering efficiency being inferior, significant power consumption, difficulty of controlling the device, and slow deposition speed.

Further, when applying high power to increase the deposition speed, there are problems in that the substrate temperature will increase, and a polycarbonate substrate will deform as a result thereof. Moreover, since ZnS-SiO₂ has a thick film thickness, there are problems in that the throughput will deteriorate and costs will increase.

Although a rewritable DVD is demanded of increased number of rewritings in addition to the realization of shorter wavelengths of the laser wavelength, realization of a large capacity and high speed recording are also strongly demanded. Still, the foregoing ZnS-SiO₂ material possesses other problems.

As one reason that the number of times that rewrite the optical information recording medium will deteriorate, there is a problem in that a gap will be formed between the recording layer and protective layer during the repeated heating and cooling of the recording layer material disposed between ZnS-SiO₂. Thus, this causes the deterioration of characteristics to the reflectivity and the like.

Although an intermediate layer having nitride or carbide as its principal component is provided between the recording layer and protective layer in order to improve the adhesiveness of the foregoing materials, there are problems in that the throughput will deteriorate and costs will increase as a result of the increased number of layers.

In order to overcome these problems, considered was the improvement of adhesiveness with the recording layer by securing an amorphous nature that is more stable than the protective layer material ZnS-SiO₂.

Since a ZnO base homologous compound (c.f. technical journal "Solid Physics" C. Li et al., Vol. 35, No. 1, 2000, page 23 to 32 "Microscopic Observation of Modulated Structure of Homologous Compound RMO₃(ZnO)ₘ (R = In, Fe; M = In, Fe, Ga, Al; m = natural number)") has a complex layer structure, it is characterized in that it is capable of stably retaining the amorphous nature during deposition, is transparent in the used wavelength range, and the refractive index is also similar to ZnS-SiO₂.

As a result of adding this ZnO base homologous compound to ZnS, this has been expected to improve the amorphous nature, and, by excluding the insulation material SiO₂, stabilize the sputtering characteristics, improve the characteristics of the optical information recording medium, and improve the productivity thereof.

Generally speaking, as examples of using a material having a homologous compound as its principal component as a transparent conductive material, for instance, there is a method of forming a zinc-indium oxide target via laser abrasion (c.f. Japanese Patent Laid-Open Publication No. 2000-26119), an example of a transparent conductive film containing amorphous nature oxide and having favorable conductivity and in particular favorable blue light permeability (c.f. Japanese Patent Laid-Open Publication 2000-44236), and an example of a moisture resistance film forming target having In and Zn as its principal components, which is In₂O₃(ZnO₂)m(m = 2 to 20), and the atomic ratio of In and Zn(In/(In + Zn)) is 0.2 to 0.85 (c.f. Japanese Patent No. 2695605).

Nevertheless, it could not be said that the material forming the foregoing transparent conductive film was sufficient as a thin film for an optical information recording medium (in particular for use as a protective film).

Meanwhile, with the compound target obtained by adding a ZnO based homologous compound to ZnS, there is a problem in that it is difficult to increase the bulk density, and only a low density sintered body target can be obtained.

With this kind of low density target, there are problems in that arcing easily occurs during the formation of the film via sputtering, particles (dust) and nodules will generate during sputtering as a result of such arcing, and, not only will the uniformity and quality of deposition deteriorate, the productivity will also deteriorate.

### DISCLOSURE OF THE INVENTION

An object of the present invention is to provide a high density sputtering target that, upon forming a film via sputtering, enables reducing the influence of heat on a substrate, high speed deposition, adjustment for thinning the film thickness, reduction of the generation of particles (dust) and nodules during sputtering, and improving the productivity with small variation in quality, and in which the crystal grains are fine, as well as the manufacturing method thereof. In particular, obtained is a thin film for an optical information recording medium optimum for use as a protective film, as well as the manufacturing method thereof.

In order to achieve the foregoing object, as a result of intense study, the present inventors discovered that, by adopting a compound having zinc chalcogenide such as ZnS and ZnO as its principal component, the superior characteristics such as optical characteristics, heat characteristics and adhesiveness with the recording layer is employed efficiently, DC sputtering is enabled by the retention of conductivity, and, by increasing the density thereof, characteristics as the protective film can be maintained, the generation of particles and nodules upon sputtering can be reduced, and the uniformity of the film thickness can also be improved.

Based on the foregoing discovery, the present invention provides:
1. A sputtering target containing a compound having as its principal component zinc oxide satisfying A_{X}B_{Y}O_{(KaX + KbY)/2}(ZnO)ₘ, 0<X<2, Y = 2-X, 1 ≦ m, where A and B are respectively different positive elements of trivalence or more, and the valencies thereof are respectively Ka and Kb, as well as zinc chalcogenide;
2. A sputtering target containing a compound having as its principal component zinc oxide satisfying A_{X}B_{Y}O_{(KaX + KbY)/2}(ZnO)ₘ, 0<X<2, Y = 2-X, 1≦m, where A and B are respectively different positive elements of trivalence or more, and the valencies thereof are respectively Ka and Kb, as well as zinc chalcogenide, and having a relative density of 90% or more and a bulk resistance value of 0.1 Ωcm or less;
3. The sputtering target according to paragraph 1 or paragraph 2 above, containing a compound having as its principal component zinc oxide satisfying 2≦m;
4. The sputtering target according to any one of paragraphs 1 to 3 above, wherein A is indium;
5. The sputtering target according to any one of paragraphs 1 to 4 above, containing a compound having as its principal component zinc oxide at a volume ratio of 25% or more in relation to zinc chalcogenide;
6. The sputtering target according to any one of paragraphs 1 to 5 above, wherein the scope of variation of elements other than zinc in the target is within 0.5wt%;
7. The sputtering target according to any one of paragraphs 1 to 6 above, wherein the scope of variation of density in the target is within 3%;
8. The sputtering target according to any one of paragraphs 1 to 7 above, wherein the variation of bulk resistance in the target is within 40% in relation to the average value; and
9. The sputtering target according to any one of paragraphs 1 to 8 above, wherein the average crystal grain size in the target is 10 µm or less, and comprising a texture where the oxide having zinc oxide as its principal component and chalcogenide are evenly dispersed.
   The present invention also provides:
10. A thin film for an optical information recording medium formed by using the sputtering target according to any one of paragraphs 1 to 9 above;
11. The thin film for an optical information recording medium according to paragraph 10 above, which is used adjacent to a recording layer;
12. A manufacturing method of a thin film for an optical information recording medium, wherein the sputtering target according to any one of paragraphs 1 to 9 above is used to form a thin film via direct current sputtering;
13. The manufacturing method of the sputtering target according to any one of paragraphs 1 to 9 above, wherein normal pressure sintering or high temperature pressure sintering is performed to the oxide powder and chalcogenide powder of the respective constituent elements having an average grain size of 5 µm or less;
14. The manufacturing method of the sputtering target according to paragraph 13 above, wherein the oxide powder having as its principal component zinc oxide is mixed evenly and then calcinated at 800 to 1300°C before sintering;
15. The manufacturing method of the sputtering target according to paragraph 14 above, wherein the material is pulverized to 1 µm or less after calcination;
16. The manufacturing method of the sputtering target according to any one of paragraphs 12 to 15 above, wherein sintering is performed in a vacuum or under an inert atmosphere such as an argon or nitrogen atmosphere; and
17. The manufacturing method of the sputtering target according to any one of paragraphs 12 to 16 above, wherein the oxide powder before sintering preliminarily forms a compound having as its principal component zinc oxide.

### BEST MODE FOR CARRYING OUT THE EMBODIMENTS

The sputtering target of the present invention contains, in addition to zinc chalcogenide, a compound having as its principal component zinc oxide satisfying A_{X}B_{Y}O_{(KaX + KbY)/2}(ZnO)ₘ, 0<X<2, Y = 2-X, 1≦m, and even 2≦m, where A and B are respectively different positive elements of trivalence or more, and the valencies thereof are respectively Ka and Kb.

In particular, as A and B, at least one or more elements selected from aluminum, gallium, indium, scandium, yttrium, lanthanum, vanadium, chrome, manganese, iron, niobium, tantalum, germanium, tin, antimony and so on are used. In particular, indium is preferably used as A.

Further, preferably, the compound having as its principal component zinc oxide described above is contained at a volume ratio of 25% or more in relation to zinc chalcogenide.

By adding a compound having as its principal component zinc oxide as described above, the present invention is able to retain the conductivity of the target, and a thin film can thereby be formed via direct current sputtering (DC sputtering).

DC sputtering, in comparison to RF sputtering, is superior in that the deposition speed is fast, and the sputtering efficiency is favorable.

Further, the DC sputtering device has advantages in that it is inexpensive, easy to control, and has low power consumption. Since the film thickness of the protective film itself can also be made thin, productivity improvement and substrate heating prevention effects can also be yielded.

Therefore, by using the sputtering target of the present invention, the productivity will improve, and high quality materials can be obtained. Thus, there is a significant effect in that an optical recording medium with an optical disk protective film can be manufactured inexpensively and stably.

With the target of the present invention, it is desirable that the scope of variation of elements other than zinc in the target is within 0.5wt%, and even within 0.3%, the scope of variation of density in the target is within 3%, and even within 1.5%, the variation of bulk resistance in the target is within 40%, and even within 20%, in relation to the average value, and the average crystal grain size in the target is 10 µm or less, and comprising a texture where the oxide having zinc oxide as its principal component and chalcogenide are evenly dispersed.

As a result, even deposition is possible, and a thin film for an optical information recording medium (protective film) having superior characteristics can be formed.

The target of the present invention may be used to form a thin film for an optical information recording medium (protective film), and this protective film is at least used adjacent to the recording layer.

Normal pressure sintering or high temperature pressure sintering is performed to the oxide powder and chalcogenide powder of the respective constituent elements having an average grain size of 5 µm or less in order to manufacture a high density sputtering target.

Further, it is desirable that the oxide powder having as its principal component zinc oxide is mixed evenly and then calcinated at 800 to 1300°C before sintering, and pulverized to 1 µm or less after calcination. Sintering should be performed in a vacuum or under an inert atmosphere such as an argon or nitrogen atmosphere. As a result, a sputtering target having a relative density or 90% or more can be obtained. It is desirable that the oxide powder before sintering preliminarily forms a compound having as its principal component zinc oxide. This will increase the uniformity, more effectively yield the advantage of the homologous compound, and stabilize the amorphous nature.

As a result of using the sputtering target of the present invention, a significant effect is yielded in that the productivity can be improved, high quality materials can be obtained, and an optical recording medium with an optical disk protective film can be manufactured inexpensively and stably.

Since the improved density of the sputtering target of the present invention will reduce pores and miniaturize crystal grains, the sputter face of the target can be made even and smooth. Thus, a significant effect is yielded in that the particles and nodules during sputtering can be reduced, the target life can be prolonged, variation in quality can be reduced, and the productivity can also be improved.

### Examples and Comparative Examples

The present invention is now explained in detail with reference to the Examples and Comparative Examples. Incidentally, these Examples are merely illustrative, and the present invention shall in no way be limited thereby. In other words, the present invention shall only be limited by the scope of claim for a patent, and shall include the various modifications other than the Examples of this invention.

### (Example 1)

In₂O₃ powder equivalent to 4N and 5 µm or less, Al₂O₃ powder equivalent to 4N and 1 µm or less and ZnO powder equivalent to 4N and having an average grain size of 5 µm or less were prepared, blended to become In_{1.0}Al_{1.0}O₃(ZnO)₃, subject to wet blending, dried, and thereafter calcinated at 1100°C.

After calcination, this was subject to wet pulverization until the average grain size became equivalent to 1 µm, then dried. This In_{1.0}Al_{1.0}O₃(ZnO)₃ powder and ZnS powder equivalent to 4N and having an average grain size of 5 µm or less were mixed to become ZnS:In_{1.0}Al_{1.0}O₃(ZnO)₃ = 70:30vol%. This mixed powder was filled in a carbon mold, and hot pressed at a temperature of 1000°C to obtain a target material. The relative density of this target material was 92%.

This target material was processed to become a 6 inch φsize target, and then sputtered. The sputtering conditions were DC sputtering, sputtering power of 1000W, Ar gas pressure of 0.5Pa, and the target was deposited on a glass substrate with a target film thickness of 1500Å. The transmittance of the deposited sample was 95% (wavelength 650nm), and the refractive index was 2.2 (wavelength 633nm).

Further, the deposited sample was measured by XRD (Cu-K α, 40kV, 30mA, hereinafter the same) before and after the annealing treatment (600°C x 30min, Ar flow). According to the measurement, a specific crystal peak could not be observed, and a stable amorphous nature was maintained.

The chemical composition, blend ratio, relative density, capability of DC sputtering, refractive index and amorphous nature (maximum peak intensity ratio against an undeposited glass substrate in 2 θ = 20 to 60°) of the target of Example 1 are shown in Table 1.

**Table 1**

| Examples | Composition (Component Ratio) | Density (%) | DC Sputtering | Refractive Index | Amorphous Nature |
|---|---|---|---|---|---|
| Example 1 | ZnS:In_{1.0}Al_{1.0}O₃(ZnO)₃ = 70:30vol% | 92 | Enable | 2.2 | 1.6 |
| Example 2 | ZnS:In_{1.2}Al_{0.8}O₃(ZnO)₄ = 65:35vol% | 90 | Enable | 2.1 | 1.5 |
| Example 3 | ZnS:In_{1.1}Ga_{0.9}O₃(ZnO)_{4.2} = 70:30vol% | 95 | Enable | 2.2 | 1.0 |
| Example 4 | ZnS:In_{1.0}Ga_{1.0}O₃(ZnO)₇ = 70:30vol% | 94 | Enable | 2.2 | 1.1 |
| Example 5 | ZnS:In_{1.5}Fe_{0.5}O₃(ZnO)₂ = 75:25vol% | 90 | Enable | 2.5 | 1.4 |
| Example 6 | ZnS:In_{1.0}Sn_{1.0}O_{3.5}(ZnO)₄ 70:30vol% | 93 | Enable | 2.3 | 1.1 |
| Example 7 | ZnS:In_{1.0}Al_{0.5}Ga_{0.5}O₃(ZnO)₅ = 65:35vol% | 92 | Enable | 2.2 | 1.2 |
| Comparative Example 1 | ZnS:In_{0.5}Al_{1.5}O₃(ZnO)_{0.8} = 70:30vol% | 92 | Enable | 2.2 | 9.0 |
| Comparative Example 2 | ZnS:In_{1.0}Al_{1.0}O₃(ZnO)₃ = 90:10vol% | 83 | Not Enable | 2.1 | 2.5 |
| Comparative Example 3 | ZnS:In_{0.2}Ga_{1.8}O₃(ZnO)_{0.5} = 70:30vol% | 82 | Enable | 2.2 | 5.2 |
| Comparative Example 4 | ZnS:Fe_{1.0}Al_{1.0}O3(ZnO)_{0.25} = 70:30vol% | 90 | Enable | 2.5 | 7.0 |

Amorphous nature is represented in a maximum peak intensity ratio against an undeposited glass substrate of 2 θ= 20 to 60°.

### (Examples 2 to 7)

A target was manufactured under the same conditions as Example 1 other than that the composition of the A_{X}B_{Y}O_{(KaX + KbY)/2}(ZnO)ₘ compound was changed, and the ratio to ZnS was also changed, and the chemical composition, blend ratio, relative density, capability of DC sputtering, refractive index and amorphous nature of the target were also examined as with Example 1. The results are shown in Table 1.

According to the results, the relative density of every target was 90% or more, DC sputtering was enabled, refractive index was 2.1 to 2.2, no specific crystal peak could be observed, and a stable amorphous nature was maintained in all the Examples.

### (Comparative Example 1)

In₂O₃ powder equivalent to 4N and 5 µm or less, Al₂O₃ powder equivalent to 4N and 1 m µm or less and ZnO powder equivalent to 4N and having an average grain size of 5 µm or less were prepared, blended to become In_{0.5}Al_{1.5}O₃(ZnO)_{0.8}, subject to wet blending, dried, and thereafter calcinated at 1100°C.

After calcination, this was subject to wet pulverization until the average grain size became equivalent to 1 µm, then dried. This In_{0.5}Al_{1.5}O₃(ZnO)_{0.8} powder and ZnS powder equivalent to 4N and having an average grain size of 5 µm or less were mixed to become ZnS:In_{0.5}Al_{1.5}O₃(ZnO)_{0.8} = 70:30vol%.

This mixed powder was filled in a carbon mold, and hot pressed at a temperature of 1000°C to obtain a target material. The relative density of this target material was 92%.

This target material was processed to become a 6 inch φ size target, and then sputtered. The sputtering conditions were DC sputtering, sputtering power of 1000W, Ar gas pressure of 0.5Pa, and the target was deposited on a glass substrate with a target film thickness of 1500Å. The transmittance of the deposited sample was 90% (wavelength 650nm), and the refractive index was 2.2 (wavelength 633nm).

Further, the deposited sample was measured by XRD before and after the annealing treatment (600°C x 30min, Ar flow). According to the measurement, a crystal peak could be observed in this Comparative Example since the ratio of ZnO was low.

The chemical composition, blend ratio, relative density, capability of DC sputtering, refractive index and amorphous nature (maximum peak intensity ratio against an undeposited glass substrate in 2 θ= 20 to 60°) of the target of Comparative Example 1 are shown in Table 1.

### (Comparative Examples 2 to 4)

A target was manufactured under the same conditions as Comparative Example 1 other than that the composition of the A_{X}B_{Y}O_{(KaX + KbY)/2}(ZnO)ₘ compound was changed, and the ratio to ZnS was also changed, and the chemical composition, blend ratio, relative density, capability of DC sputtering, refractive index and amorphous nature of the target were also examined as with Comparative Example 1. The results are shown in Table 1.

According to the results, although the refractive index of Comparative Example 2 was in the range of 2.1 to 2.2, DC sputtering was not enabled since the blend ratio of the A_{X}B_{Y}O_{(KaX + KbY)/2}(ZnO)ₘ compound was low, and the relative density was low at 83%.

Although the refractive index of both Comparative Example 3 and Comparative Example 4 was in the range of 2.1 to 2.5, a crystal peak could be observed since the ratio of ZnO was low, and the amorphous nature was unstable.

In foregoing Examples 1 to 7, although indium, aluminum, iron, tin and gallium were used as the positive elements (A, B) of trivalence or more, cases of employing one or more elements selected from scandium, yttrium, lanthanum, vanadium, chrome, manganese, niobium, tantalum, germanium, antimony and so on which are positive elements of trivalence or more also showed similar results as with Examples 1 to 7 (these results have been omitted since they were redundant and complex.) Also, the same results were obtained when the foregoing elements were combined.

### (Example 8)

In₂O₃ powder equivalent to 4N and 5 µm or less, Al₂O₃ powder equivalent to 4N and 1 µm or less and ZnO powder equivalent to 4N and having an average grain size of 5 µm or less were prepared, blended to become In_{1.0}Al_{1.0}O₃(ZnO)₃, subject to wet blending, dried, and thereafter calcinated at 1100°C.

A crystal peak of In_{1.0}Al_{1.0}O₃(ZnO)₃ was observed with the XRD measurement after calcination. This calcinated powder was subject to wet pulverization until the average grain size became equivalent to 1 µm, then dried. This In_{1.0}Al_{1.0}O₃(ZnO)₃ powder and ZnS powder equivalent to 4N and having an average grain size of 5 µm or less were mixed to become ZnS:In_{1.0}Al_{1.0}O₃(ZnO)₃ = 70:30vol%. Mixing was performed with a wet ball mill or high speed mixer to evenly disperse this mixed powder.

Next, this mixed powder was filled in a carbon mold, and hot pressed at a temperature of 900°C to obtain a target material. The relative density of this target material was 92%. The average crystal grain size in the target material was 4 µm.

Results of the measurement of the composition (ICP method) and density (Archimedes method) upon sampling from three arbitrary locations in the target as well as the results of the measurement of the bulk resistance (four-terminal method) in five arbitrary locations on the sputtering face of the target subject to smoothing treatment are shown in Table 2. As shown in Table 2, a result showing extremely small variations in the composition, density and bulk resistance value was obtained.

In addition, this target material was processed to become a 6 inch φ size target, and then sputtered. The sputtering conditions were DC sputtering, sputtering power of 1000W, Ar gas pressure of 0.5Pa, and the target was deposited with a target film thickness of 1500Å. The transmittance of the deposited sample was 95% (wavelength 650nm), and the refractive index was 2.2 (wavelength 633nm).

Further, the deposited sample was measured by XRD (Cu-K α, 40kV, 30mA, hereinafter the same) before and after the annealing treatment (600°C x 30min, Ar flow). According to the measurement, a specific crystal peak could not be observed, and a stable amorphous nature was maintained.

**Table 2**

| Example | Composition (wt%) | Density (%) | Bulk Resistance (Ωcm) |
|---|---|---|---|
| Example 8 | In: 8.2, 8.2, 8.3 Al: 2.9, 2.9, 2.8 | 92.0, 92.4, 92.5 | 0.021, 0.022, 0.025, 0.019, 0.023 |
| Example 9 | In: 8.1, 8.0, 8.0 Ga: 4.8, 4.9, 4.8 | 92.8, 93.5, 93.1 | 0.021, 0.022, 0.025, 0.019, 0.023 |
| Example 10 | In: 8.4, 8.2, 8.3 Sn: 4.3, 4.2, 4.2 | 90.8, 91.2, 91.4 | 0.034, 0.037, 0.028, 0.030, 0.032 |
| Example 11 | In: 12.2, 12.1, 11.9 Cr: 0.6, 0.5, 0.6 | 94.3, 94.0, 93.9 | 0.042, 0.048, 0.051, 0.038, 0.037 |
| Comparative Example 5 | In: 8.6, 8.1, 8.0 Al: 2.4, 2.5, 3.0 | 80.0, 82.4, 85.5 | 0.35, 1.32, 1.54, 0.98, 0.64 |
| Comparative Example 6 | In: 15.0, 15.9, 14.2 Ga : 9.2, 9.3, 8.7 | 75.2, 80.7, 80.1 | 0.2, 2.5, 0.4, 3.0, 0.7 |

### (Example 9)

In₂O₃ powder equivalent to 4N and 5 µm or less, Ga₂O₃ powder equivalent to 4N and 3 µm or less and ZnO powder equivalent to 4N and having an average grain size of 5 µm or less were prepared, blended to become In_{1.0}Ga_{1.0}O₃(ZnO)₃, subject to wet blending, dried, and thereafter calcinated at 1100°C.

A crystal peak of In_{1.0}Ga_{1.0}O₃(ZnO)₃ was observed with the XRD measurement after calcination. This calcinated powder was subject to wet pulverization until the average grain size became equivalent to 1 µm, then dried. This In_{1.0}Ga_{1.0}O₃(ZnO)₃ powder and ZnS powder equivalent to 4N and having an average grain size of 5 µm or less were mixed to become ZnS:In_{1.0}Ga_{1.0}O₃(ZnO)₃ = 70:30vol%. Mixing was performed with a wet ball mill or high speed mixer to evenly disperse this mixed powder.

Next, this mixed powder was filled in a carbon mold, and hot pressed at a temperature of 950°C to obtain a target. The relative density of this target was 94%. The average crystal grain size in the target was 3.5 µm.

Results of the measurement of the composition (ICP method) and density (Archimedes method) upon sampling from three arbitrary locations in the target as well as the results of the measurement of the bulk resistance (four-terminal method) in five arbitrary locations on the sputtering face of the target subject to smoothing treatment are shown in Table 2. As shown in Table 2, a result showing extremely small variations in the composition, density and bulk resistance value was obtained.

In addition, this target was processed to become a 6 inch φ size target, and then sputtered. The sputtering conditions were DC sputtering, sputtering power of 1000W, Ar gas pressure of 0.5Pa, and the target was deposited with a target film thickness of 1500Å. The transmittance of the deposited sample was 98% (wavelength 650nm), and the refractive index was 2.2 (wavelength 633nm).

Further, the deposited sample was measured by XRD before and after the annealing treatment (600°C × 30min, Ar flow). According to the measurement, a specific crystal peak could not be observed, and a stable amorphous nature was maintained.

### (Example 10)

In₂O₃ powder equivalent to 4N and 5 µm or less, SnO powder equivalent to 4N and 3 µm or less and ZnO powder equivalent to 4N and having an average grain size of 5 µm or less were prepared, blended to become In_{1.0}Sn_{1.0}O_{3.5}(ZnO)₄, subject to wet blending, dried, and thereafter calcinated at 1100°C.

A crystal peak of In_{1.0}Sn_{1.0}O_{3.5}(ZnO)₄ was observed with the XRD measurement after calcination. This calcinated powder was subject to wet pulverization until the average grain size became equivalent to 1 µm, then dried. This In_{1.0}Sn_{1.0}O_{3.5}(ZnO)₄ powder and ZnS powder equivalent to 4N and having an average grain size of 5 µm or less were mixed to become ZnS:In_{1.0}Sn_{1.0}O_{3.5}(ZnO)₄ = 70:30vol%. Mixing was performed with a wet ball mill or high speed mixer to evenly disperse this mixed powder.

Next, this mixed powder was filled in a carbon mold, and hot pressed at a temperature of 950°C to obtain a target. The relative density of this target was 91 %. The average crystal grain size in the target was 3.5 µm.

Results of the measurement of the composition (ICP method) and density (Archimedes method) upon sampling from three arbitrary locations in the target as well as the results of the measurement of the bulk resistance (four-terminal method) in five arbitrary locations on the sputtering face of the target subject to smoothing treatment are shown in Table 2. As shown in Table 2, a result showing extremely small variations in the composition, density and bulk resistance value was obtained.

In addition, this target was processed to become a 6 inch φ size target, and then sputtered. The sputtering conditions were DC sputtering, sputtering power of 1000W, Ar gas pressure of 0.5Pa, and the target was deposited with a target film thickness of 1500Å. The transmittance of the deposited sample was 95% (wavelength 650nm), and the refractive index was 2.3 (wavelength 633nm).

Further, the deposited sample was measured by XRD before and after the annealing treatment (600°C x 30min, Ar flow). According to the measurement, a specific crystal peak could not be observed, and a stable amorphous nature was maintained.

### (Example 11)

In₂O₃ powder equivalent to 4N and 5 µm or less, Cr₂O₃ powder equivalent to 4N and 3 µm or less and ZnO powder equivalent to 4N and having an average grain size of 5 µm or less were prepared, blended to become In_{1.8}Cr_{0.2}O₃(ZnO)₃, subject to wet blending, dried, and thereafter calcinated at 1100°C.

A crystal peak of In_{1.8}Cr_{0.2}O₃(ZnO)₅ was observed with the XRD measurement after calcination. This calcinated powder was subject to wet pulverization until the average grain size became equivalent to 1 µm, then dried. This In_{1.8}Cr_{0.2}O₃(ZnO)₅ powder and ZnS powder equivalent to 4N and having an average grain size of 5 µm or less were mixed to become ZnS:In_{1.8}Cr_{0.2}O₃(ZnO)₅ = 60:40vol%. Mixing was performed with a wet ball mill or high speed mixer to evenly disperse this mixed powder.

Next, this mixed powder was filled in a carbon mold, and hot pressed at a temperature of 950°C to obtain a target. The relative density of this target was 94%. The average crystal grain size in the target was 4.0 µm.

Results of the measurement of the composition (ICP method) and density (Archimedes method) upon sampling from three arbitrary locations in the target as well as the results of the measurement of the bulk resistance (four-terminal method) in five arbitrary locations on the sputtering face of the target subject to smoothing treatment are shown in Table 2. As shown in Table 2, a result showing extremely small variations in the composition, density and bulk resistance value was obtained.

In addition, this target was processed to become a 6 inch φ size target, and then sputtered. The sputtering conditions were DC sputtering, sputtering power of 1000W, Ar gas pressure of 0.5Pa, and the target was deposited with a target film thickness of 1500Å. The transmittance of the deposited sample was 92% (wavelength 650nm), and the refractive index was 2.3 (wavelength 633nm).

Further, the deposited sample was measured by XRD before and after the annealing treatment (600°C x 30min, Ar flow). According to the measurement, a specific crystal peak could not be observed, and a stable amorphous nature was maintained.

### (Comparative Example 5)

In₂O₃ powder equivalent to 4N and 5 µm or less, Al₂O₃ powder equivalent to 4N and 1 µm or less and ZnO powder equivalent to 4N and having an average grain size of 5 µm or less were prepared, blended to become In_{1.0}Al_{1.0}O₃(ZnO)₃, and ZnS powder equivalent to 4N and having an average grain size of 5 µm or less was further mixed to become ZnS:In_{1.0}Al_{1.0}O3(ZnO)₃ = 70:30vol%.

Next, this mixed powder was filled in a carbon mold, and hot pressed at a temperature of 900°C to obtain a target. The relative density of this target was 82%. The average crystal grain size in the target was 13 µm.

Results of the measurement of the composition (ICP method) and density (Archimedes method) upon sampling from three arbitrary locations in the target as well as the results of the measurement of the bulk resistance (four-terminal method) in five arbitrary locations on the sputtering face of the target subject to smoothing treatment are shown in Table 2. As shown in Table 2, a result showing large variations in the composition, density and bulk resistance value was obtained.

In addition, this target was processed to become a 6 inch φ size target, and then sputtered. The sputtering conditions were DC sputtering, sputtering power of 1000W and Ar gas pressure of 0.5Pa, but this target had numerous abnormal electrical discharges, and DC sputtering could not be employed.

### (Comparative Example 6)

In₂O₃ powder equivalent to 4N and 5 µm or less, Ga₂O₃ powder equivalent to 4N and 1 µm or less and ZnO powder equivalent to 4N and having an average grain size of 5 µm or less were prepared, blended to become InGaO₃(ZnO)_{0.7}, and ZnS powder equivalent to 4N and having an average grain size of 5 µm or less was further mixed to become ZnS:InGaO₃(ZnO)_{0.7} = 60:40vol%.

Next, this mixed powder was filled in a carbon mold, and hot pressed at a temperature of 900°C to obtain a target. The relative density of this target was 78%. The average crystal grain size in the target was 11 µm.

Results of the measurement of the composition (ICP method) and density (Archimedes method) upon sampling from three arbitrary locations in the target as well as the results of the measurement of the bulk resistance (four-terminal method) in five arbitrary locations on the sputtering face of the target subject to smoothing treatment are shown in Table 2. As shown in Table 2, a result showing large variations in the composition, density and bulk resistance value was obtained.

In addition, this target was processed to become a 6 inch φ size target, and then sputtered. The sputtering conditions were DC sputtering, sputtering power of 1000W and Ar gas pressure of 0.5Pa, but this target had numerous abnormal electrical discharges, and DC sputtering could not be employed.

In foregoing Examples 8 to 11, although indium, tin, chrome and gallium were used as the positive elements (A, B) of trivalence or more, cases of employing one or more elements selected from aluminum, iron, scandium, yttrium, lanthanum, vanadium, manganese, niobium, tantalum, germanium, tin, antimony and so on which are other positive elements of trivalence or more also showed similar results as with Examples 8 to 11 (these results have been omitted since they were redundant and complex.) Also, the same results were obtained when the foregoing elements were combined.

### Industrial Applicability

In the present invention, a compound (homologous compound) having ZnO as its principal component is added to zinc chalcogenide such as ZnS in order to adjust the component, seek the stability of the amorphous nature, and provide conductivity to the target. Further, by improving the adhesiveness with the recording layer material of the optical information recording medium, the characteristics of the target are improved, and, by realizing a high density of a relative density of 90% or more, stable DC sputtering can be performed.

And, a significant effect is yielded in that the sputtering controllability, which is characteristic to DC sputtering, can be facilitated, the deposition speed can be increased, and the sputtering efficiency can be improved.

As a result of the above, another significant effect is yielded in that the generation of particles (dust) and nodules during sputtering upon deposition can be reduced, the productivity can be improved with little variation in quality, and an optical recording medium with an optical disk protective film can be manufactured inexpensively and stably.

Further, as a result of the range of variation of elements other than zinc in the target, range of variation of density in the target and variation of bulk resistance in the target being small in relation to the average value, the average crystal grain size in the target being 10 µm or less, and comprising a texture in which an oxide having zinc oxide as its principal component and chalcogenide are evenly dispersed, an effect is yielded in that uniform deposition is possible, and a thin film for an optical information recording medium (protective film) having superior characteristics can be formed. Preferred features:
1. A sputtering target containing a compound having as its principal component zinc oxide satisfying A_{X}B_{Y}O_{(KaX + KbY)/2}(ZnO)ₘ, 0<X<2, Y = 2-X, 1 <=m, where A and B are respectively different positive elements of trivalence or more, and the valencies thereof are respectively Ka and Kb, as well as zinc chalcogenide.
2. A sputtering target containing a compound having as its principal component zinc oxide satisfying A_{X}B_{Y}O_{(Kax + KbY)/2}(ZnO)ₘ, 0<X<2, Y = 2-X, 1 <=m, where A and B are respectively different positive elements of trivalence or more, and the valencies thereof are respectively Ka and Kb, as well as zinc chalcogenide, and having a relative density of 90% or more and a bulk resistance value of 0.1 Ωcm or less.
3. The sputtering target according to feature 1 or feature 2, containing a compound having as its principal component zinc oxide satisfying 2<=m.
4. The sputtering target according to any one of features 1 to 3, wherein A is indium.
5. The sputtering target according to any one of features 1 to 4, containing a compound having as its principal component zinc oxide at a volume ratio of 25% or more in relation to zinc chalcogenide.
6. The sputtering target according to any one of features 1 to 5, wherein the scope of variation of elements other than zinc in the target is within 0.5wt%.
7. The sputtering target according to any one of features 1 to 6, wherein the scope of variation of density in the target is within 3%.
8. The sputtering target according to any one of features 1 to 7, wherein the variation of bulk resistance in the target is within 40% in relation to the average value.
9. The sputtering target according to any one of features 1 to 8, wherein the average crystal grain size in the target is 10 µm or less, and comprising a texture where the oxide having zinc oxide as its principal component and chalcogenide are evenly dispersed.
10. A thin film for an optical information recording medium formed by using the sputtering target according to any one of features 1 to 9.
11. The thin film for an optical information recording medium according to feature 10, which is used adjacent to a recording layer.
12. A manufacturing method of a thin film for an optical information recording medium, wherein the sputtering target according to any one of features 1 to 9 is used to form a thin film via direct current sputtering.
13. The manufacturing method of the sputtering target according to any one of features 1 to 9, wherein normal pressure sintering or high temperature pressure sintering is performed to the oxide powder and chalcogenide powder of the respective constituent elements having an average grain size of 5 µm or less.
14. The manufacturing method of the sputtering target according to feature 13, wherein the oxide powder having as its principal component zinc oxide is calcinated at 800 to 1300°C before sintering.
15. The manufacturing method of the sputtering target according to feature 14, wherein the material is pulverized to 1 µm or less after calcination.
16. The manufacturing method of the sputtering target according to any one of features 12 to 15, wherein sintering is performed in a vacuum or under an inert atmosphere such as an argon or nitrogen atmosphere.
17. The manufacturing method of the sputtering target according to any one of features 12 to 16, wherein the oxide powder before sintering preliminarily forms a compound having as its principal component zinc oxide.

## Claims

1. A thin film for an optical information recording medium containing zinc chalcogenide and a compound having as its principal component zinc oxide satisfying A_{X}B_{Y}O_{(Kax + KbY)/2}(ZnO)ₘ, 0<X<2, Y=2-X, 1 ≦ m, where A and B are respectively different positive elements of trivalence or more and the valencies thereof are respectively Ka and Kb, and having the content of zinc chalcogenide showing an amorphous nature that the maximum peak intensity ratio against an undeposited glass substrate in 2 θ = 20 to 60° is 2.0 to 1.0.

2. The thin film for an optical information recording medium according to claim 1, having the content of zinc chalcogenide showing an amorphous nature that the maximum peak intensity ratio against an undeposited glass substrate in 2 θ = 20 to 60° is 1.6 to 1.0.

3. The thin film for an optical information recording medium containing zinc chalcogenide and a compound having as its principal component zinc oxide satisfying A_{X}B_{Y}O_{(KaX + KbY)/2}(ZnO)ₘ, 0<X<2, Y=2-X, 1 ≦ m, where A and B are respectively different positive elements of trivalence or more and the valencies thereof are respectively Ka and Kb, and containing a A_{X}B_{Y}O_{(KaX + KbV)/2}(ZnO)ₘ compound having as its principal component zinc oxide at a volume ratio of 25% or more in relation to zinc chalcogenide.

4. The thin film for an optical information recording medium according to claim 1 or claim 2, containing a A_{X}B_{Y}O_{(KaX + KbY)/2}(ZnO)ₘ compound having as its principal component zinc oxide at a volume ratio of 25% or more in relation to zinc chalcogenide.

5. The thin film for an optical information recording medium according to any one of claims 1 to 4, containing a compound having as its principal component zinc oxide satisfying 2 ≦ m.

6. The thin film for an optical information recording medium according to any one of claims 1 to 5, wherein A is indium.

7. The thin film for an optical information recording medium according to any one of claims 1 to 6, being used adjacent to a recording layer.
